# EUROPEAN PATENT APPLICATION

(11) **EP 4 668 464 A1**
(43) Date of publication of application: **24.12.2025**
(21) Application number: 23924896.6
(22) Date of filing: 07.09.2023
(51) Int. Cl.: H01M 50/507, H01M 50/569

(54) **BUSBAR ASSEMBLY, CYLINDRICAL POWER BATTERY MODULE, AND BATTERY PACK**

(30) Priority: 28.02.2023 CN 202320353053 U
(71) Applicant: Eve Energy Co., Ltd., Huizhou, Guangdong 516006 (CN)
(72) Inventor: LAN, Han, Huizhou, Guangdong 516006 (CN)
(74) Representative: HGF
(86) International application number: PCT/CN2023/117507
(87) International publication number: WO 2024/178941

(57) **Abstract**

A busbar assembly, a cylindrical power battery module, and a battery pack are provided. The busbar assembly includes: an input bar connected to a battery cell at an input end of a cylindrical power battery module; an output bar connected to a battery cell at an output end of the cylindrical power battery module; current conduction bars arranged between the input bar and the output bar and configured to work in conjunction with the input bar and the output bar to connect in series in a first direction two adjacent battery cells arranged in the first direction and connect in parallel in a second direction two adjacent battery cells arranged in the second direction; and a wiring harness member, where an input end thereof is connected to at least one of the input bar, the output bar, the current conduction bars, and multiple battery cells

## Description

This application claims priority to Chinese Patent Application No. 202320353053.6 filed with the China National Intellectual Property Administration (CNIPA) on Feb. 28, 2023, the disclosure of which is incorporated herein by reference in its entirety.

### TECHNICAL FIELD

The present application relates to the field of battery technology, and more particularly to a busbar assembly, a cylindrical power battery module, and a battery pack.

### BACKGROUND

For current power batteries, a battery management system (BMS) is generally used to intelligently manage the batteries and monitor battery status based on battery temperature and voltage data. For conventional cylindrical power battery modules, a flexible printed circuit (FPC) is generally used to collect voltage and temperature signals within the module. However, current FPCs require a PCB for signal acquisition, resulting in complex manufacturing and a large footprint. Furthermore, due to the inherent properties and structural limitations of the FPC, a cable or adapter is required to connect the FPC to the BMS. This increases the number of interfaces in the temperature and voltage signal acquisition circuitry, impacting the reliability of temperature and voltage signal monitoring.

### SUMMARY

### Technical Problem

To address the deficiencies of the conventional technology, the present application aims to provide a busbar assembly with a simple structure, low cost, and high reliability.

A second object of the present application is to provide a cylindrical power battery module that facilitates low-cost monitoring of temperature and voltage signals within the battery module.

Another object of the present application is to provide a battery pack with a compact structure and high energy density.

### Technical Solution

In a first aspect, a busbar assembly is provided according to the present application, which is applied to a cylindrical power battery module. The cylindrical power battery module includes multiple battery cells. The busbar assembly includes an input bar, an output bar, a current conduction bar, and a wiring harness member. The input bar is connected to the battery cell at the input end of the cylindrical power battery module. The output bar is connected to the battery cell at the output end of the cylindrical power battery module. The current conduction bar is disposed between the input bar and the output bar, and is configured to work in conjunction with the input bar and the output bar to connect in series in a first direction two adjacent battery cells arranged in the first direction, and connect in parallel in a second direction two adjacent battery cells arranged in the second direction. An input end of the wiring harness member is connected to at least one of the input bar, the output bar, the current conduction bar, and the multiple battery cells. The wiring harness member is configured to monitor a voltage signal and a temperature signal of the battery cell corresponding to the wiring harness member.

In a second aspect, a cylindrical power battery module is provided according to the present application, which includes the busbar assembly described above. The busbar assembly further includes a plastic bracket. The input bar, the output bar, and the current conduction bar are all disposed on the plastic bracket. The plastic bracket is provided with a temperature measuring hole passing through the plastic bracket, and enables the wiring harness member to extend through the temperature measuring hole to the battery cell.

In a third aspect, a battery pack is provided according to the present application, which includes a housing, an adhesive coating layer, a liquid cooling plate, and at least one above-described cylindrical power battery module. The battery module is disposed within the housing; the adhesive coating layer is formed on an upper surface of the busbar assembly; and the liquid cooling plate is located on an upper surface of the adhesive coating layer.

### Beneficial Effects

In the present application, the wiring harness member is utilized in place of a conventional FPC, effectively simplifying the assembly process and procedures for cylindrical power battery modules. Compared with the processing and production of FPCs, the wiring harness member can effectively reduce the production cost of cylindrical power battery modules. Furthermore, the wiring harness member offers greater flexibility, facilitating layout on cylindrical power battery modules or battery packs while avoiding the need for PCBs. This reduces the volume of the cylindrical power battery module or battery pack, thereby increasing energy density. Furthermore, it allows for direct connection to a BMS assembly, eliminating the need for adapters required when connecting an FPC to the BMS assembly. This improves reliability and reduces the cost of adapters required when connecting an FPC to the BMS compared with conventional FPCs.

### BRIEF DESCRIPTION OF DRAWINGS

FIG. 1 is a schematic diagram of the three-dimensional structure of a battery pack according to an embodiment of the present application, with a housing and a liquid cooling plate removed;
FIG. 2 is an enlarged view of the structure at part A in FIG. 1;
FIG. 3 is a schematic exploded view of the structure of a busbar assembly according to an embodiment of the present application;
FIG. 4 is an enlarged view of the structure at part B in FIG. 3;
FIG. 5 is a schematic top view of the structure of the busbar assembly according to an embodiment of the present application;
FIG. 6 is a schematic bottom view of the structure of a busbar assembly according to an embodiment of the present application;
FIG. 7 is an enlarged view of the structure at part C in FIG. 6;
FIG. 8 is a schematic front view of the structure of a guide bar according to an embodiment of the present application; and
FIG. 9 is a schematic diagram of the three-dimensional structure of a battery cell according to an embodiment of the present application.

Reference numerals list:
100 battery cell
101 positive terminal
102 negative terminal
200 plastic bracket
210 first recess
211 negative electrode hole
212 positive electrode hole
213 connection groove
214 positioning post
220 second recess
230 temperature measuring hole
310 input bar
320 output bar
330 current conduction bar
331 conductive element
332 positive electrode region
333 negative electrode region
334 connecting portion
335 positioning hole
400 wiring harness member
410 first wiring harness member
411 first data acquisition wire
420 second wiring harness member
421 second data acquisition wire
422 temperature monitoring element
500 BMS assembly
600 first fixing member
700 connector.

### DETAILED DESCRIPTION

In the description of the present application, it is to be noted that the terms "upper," "lower," "front," "back," "left," "right," "vertical," "horizontal," "top," "bottom," "inner," and "outer" and the like, indicating orientations or positional relationships, are based on the orientations or positional relationships shown in the accompanying drawings and are intended solely for ease of description and simplification of the present application. They do not indicate or imply that the devices or components referred to must have a specific orientation, be constructed, or operate in a specific manner, and are therefore not to be construed as limiting the present application.

In the description of the present application, unless otherwise expressly specified or limited, the terms "first" and "second" are used for descriptive purposes only and are not to be construed as indicating or implying relative importance. The term "plurality" refers to two or more items. The term "and/or" includes any combination and all combinations of one or more of the associated listed items. In particular, reference to "the" or "an" item is intended to refer to one of a possible plurality of such items.

Furthermore, in the description of this application, it should be understood that references to directional terms such as "upper," "lower," "inner," and "outer" are described from the perspectives shown in the accompanying drawings and should not be construed as limitations on embodiments. It is further to be understood that, in the context, when an element or feature is referred to as being connected "on", "below", or "inside", or "outside" another element(s), it can be connected not only directly "on", "below", or "inside", or "outside" the other element(s), but also indirectly "on", "below", or "inside", or "outside" the other element(s) through an intermediate element.

In an embodiment, the wiring harness member includes at least one first acquisition wire arranged to extend in the first direction and configured to monitor a voltage signal. The at least one first acquisition wire is connected in a one-to-one correspondence with at least one of the input bar, the output bar, multiple current conduction bars, and multiple battery cells.

In an embodiment, the wiring harness member includes multiple first acquisition wires arranged to extend in the first direction and configured to monitor voltage signals. The multiple first acquisition wires are connected in a one-to-one correspondence with the input bar, the output bar, multiple current conduction bars, and multiple battery cells.

In an embodiment, the wiring harness member further includes at least one second acquisition wire arranged to extend in the first direction and configured to monitor a temperature signal. The at least one second acquisition wire is connected in a one-to-one correspondence with at least one of the input bar, the output bar, multiple current conduction bars, and multiple battery cells.

In an embodiment, at least one first acquisition wire is arranged on the same side of the current conduction bar in the second direction.

In an embodiment, the second acquisition wire is connected to the battery cell through a temperature monitoring element.

In an embodiment, two second acquisition wires are provided, one of the two second acquisition wires is connected to the battery cell closest to the input bar, and the other of the two second acquisition wires is connected to the battery cell closest to the output bar.

In an embodiment, a connector is arranged at an output end of the wiring harness member, and the connector is configured to connect, by plugging, the wiring harness member to a BMS assembly.

In an embodiment, a first fixing member is provided on the wiring harness member, and a second fixing member is provided on an inner wall of the housing; and the first fixing member is detachably connected to the second fixing member.

In an embodiment, in the at least one battery module, the plastic brackets of two adjacent battery modules are integrally molded to form an integrated mounting frame. The input bars, the output bars, the current conduction bars, and the wiring harness members corresponding to the battery modules are all assembled on the integrated mounting frame.

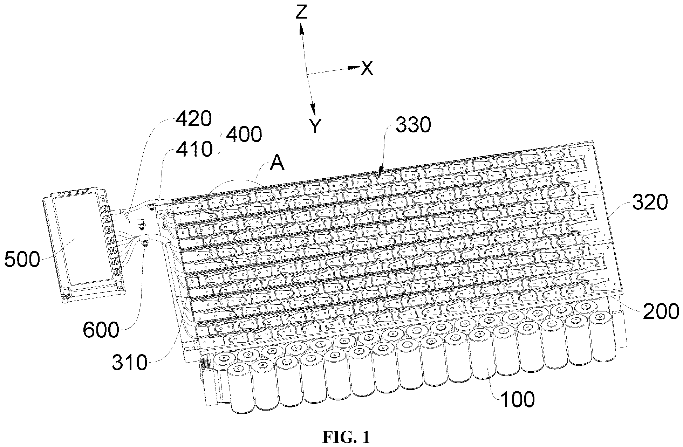

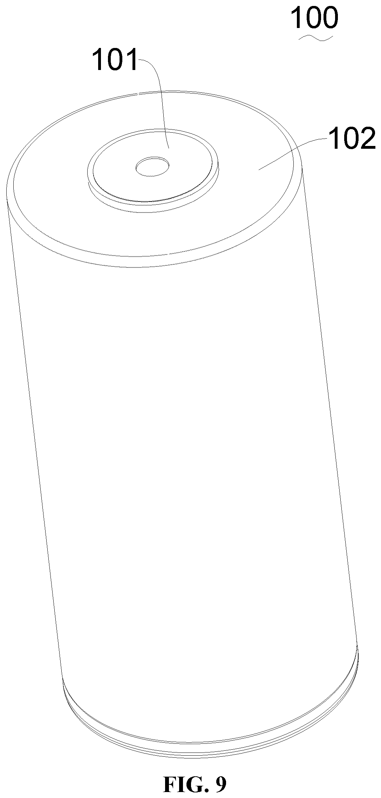

Referring to FIGS. 1 to 9, a busbar assembly is applied to a cylindrical power battery module. The cylindrical power battery module includes multiple battery cells 100. As shown in FIGS. 1 and 9, a positive terminal 101 and a negative terminal 102 of a battery cell 100 are on the same side, and the positive terminal 101 protrudes from the negative terminal 102 in an axial direction of the battery cell 100.

Specifically, the busbar assembly includes an input bar 310, an output bar 320, a current conduction bar 330, and a wiring harness member 400. The input bar 310 is connected to the battery cell 100 at the input end of the cylindrical power battery module. The output bar 320 is connected to the battery cell 100 at the output end of the cylindrical power battery module. The current conduction bar 330 is disposed between the input bar 310 and the output bar 320, and is configured to work in conjunction with the input bar 310 and the output bar 320 to connect in series in a first direction two adjacent battery cells 100 arranged in the first direction, and connect in parallel in a second direction two adjacent battery cells 100 arranged in the second direction. An input end of the wiring harness member 400 is connected to at least one of the input bar 310, the output bar 320, the current conduction bar 330, and the multiple battery cells 100, and the wiring harness member 400 is configured to monitor a voltage signal and a temperature signal of the battery cell 100 corresponding to the wiring harness member 400. The input bar 310 here, in conjunction with the current conduction bar 330 and the output bar 320, connects the battery cells 100 in the same column of the cylindrical power battery module in series in the first direction. By selectively connecting the wiring harness member 400 to the input bar 310, output bar 320, current conduction bar 330, and battery cells 100, temperature and voltage signal acquisition is realized. Here, the wiring harness member 400 is utilized in place of a conventional FPC, effectively simplifying the assembly process and procedures for cylindrical power battery modules. Compared with the processing and production of FPCs, the wiring harness member 400 can effectively reduce the production cost of cylindrical power battery modules. Furthermore, the wiring harness member 400 offers greater flexibility, facilitating layout on cylindrical power battery modules or battery packs while avoiding the need for PCBs. This reduces the volume of the cylindrical power battery module or battery pack, thereby increasing energy density. Furthermore, it allows for direct connection to a BMS assembly 500, eliminating the need for adapters required when connecting an FPC to the BMS assembly 500. This improves reliability and reduces the cost of adapters required when connecting an FPC to the BMS compared with conventional FPCs.

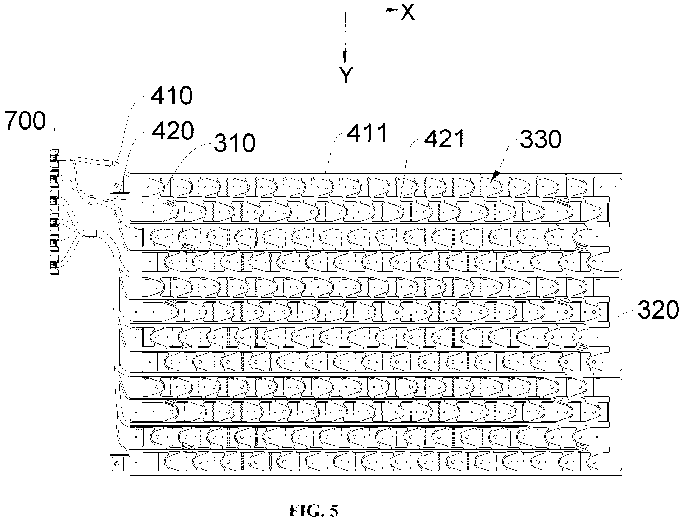

In this embodiment, the first direction is the X direction, as shown in FIGS. 1 and 5, and the second direction is the Y direction, as shown in FIGS. 1 and 5. In this embodiment, multiple battery cells 100 for constituting a cylindrical power battery module are arranged in an array in a first direction, forming a battery unit of the cylindrical power battery module. The cylindrical power battery module in this embodiment includes two parallel battery units. As shown in FIG. 1, to improve energy density, the two parallel battery units are stacked in the second direction, and the battery cells 100 of the two battery units are arranged to be staggered in the first direction, allowing more cylindrical battery cells 100 to be arranged within the same area. The battery cell 100 connected to the input bar 310 is defined as a first cell, and the cell adjacent to the first cell in the first direction is defined as a second cell. That is, in the first direction, the battery cells 100 of the battery unit are defined as the first cell, the second cell, ..., the N^{th} cell (N≥1, a positive integer). In other words, one battery unit includes N battery cells 100 arranged in an array in the first direction. In use, the input bar 310 is connected to the positive terminal 101 of the first battery. One terminal of a current conduction bar 330 adjacent to the input bar 310 in the first direction is connected to the negative terminal 102 of the first battery, and a second terminal of the current conduction bar 330 is connected to the positive terminal 101 of the second battery. It may be understood that the number of the current conduction bars 330 between the input bar 310 and the output bar 320 in the first direction is N-1. For example, if a battery unit has ten battery cells 100 arranged in an array in the first direction, then nine current conduction bars 330 are required to connect these ten battery cells 100 in series. Similarly, one terminal of the (N-1)^{th} current conduction bar 330 is connected to the negative terminal 102 of the (N-1)^{th} battery cell 100, the other end of the (N-1)^{th} current conduction bar 330 is connected to the positive terminal 101 of the N^{th} battery cell 100, and the output bar 320 is connected to the negative terminal 102 of the N^{th} battery cell 100, thereby achieving a series connection of the N battery cells 100 in the first direction by the input bar 310, the current conduction bars 330, and the output bar 320. Moreover, the battery cells 100 of two battery units stacked in the second direction are connected in parallel by the current conduction bars 330, thereby evenly distributing the current of the multiple battery cells 100 of the two battery units stacked in the second direction, ensuring the reliability of the connection between the battery cells 100.

In other embodiments, one cylindrical power battery module may include one or more battery units. When the cylindrical power battery module is composed of multiple battery units, that is, the multiple battery units of the cylindrical power battery module are stacked in the second direction. Accordingly, the current conduction bar 330 can connect the multiple battery units in parallel in the second direction. It should be noted that the input copper bar and the output copper bar each have multiple terminals in one-to-one correspondence with multiple battery cells, which are configured to be connected to the positive terminals 101 or negative terminals 102 of the battery cells 100, to connect, in the second direction, the first or last battery cells 100, in the first direction, of the multiple battery units 100 in parallel.

Furthermore, the wiring harness member 400 includes at least one first acquisition wire 411 arranged to extend in the first direction and configured to monitor a voltage signal. The at least one first acquisition wire 411 is connected in a one-to-one correspondence with at least one of the input bar 310, the output bar 320, multiple current conduction bars 330, and multiple battery cells 100. To more comprehensively and accurately monitor the voltage signals within the cylindrical power battery module, further, the wiring harness member 400 includes multiple first acquisition wires 411 arranged to extend in the first direction and configured to monitor voltage signals. The multiple first acquisition wires 411 are connected in a one-to-one correspondence with the input bar 310, the output bar 320, multiple current conduction bars 330, and multiple battery cells 100. This arrangement enables voltage monitoring of all battery cells 100, providing enhanced safety.

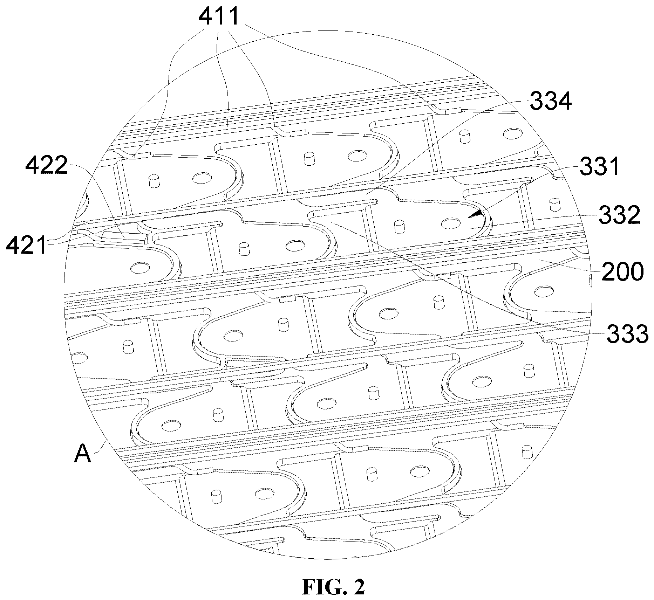

As shown in FIGS. 1 and 2, in this embodiment, to optimize wiring and improve the neatness of the busbar assembly, the number of multiple first acquisition wires 411 in a single cylindrical power battery module equals the total number of multiple current conduction bars 330, one input bar 310, and one output bar 320. All the multiple first acquisition wires 411 extend in the first direction and are located on one side of the current conduction bar 330. Specifically, as shown in FIG. 1, multiple first data acquisition wires 411 corresponding to a cylindrical power battery module are clustered together to form a first wiring harness 410. This wiring harness is located above the current conduction bar 330, that is, outside the current conduction bar 330 in a Z direction, and at one side of the current conduction bar 330 in the Y direction (that is, the second direction). The multiple first data acquisition wires 411 are connected in a one-to-one correspondence with the input bar 310, the output bar 320, and the multiple current conduction bars 330. Because each of the input bar 310, the output bar 320, and the current conduction bars 330 can connect two adjacent battery cells 100 in parallel in the second direction, the voltage signals of two adjacent battery cells 100 in the second direction can be indirectly measured by monitoring the voltage signal of only one current conduction bar 330. This reduces the number of first data acquisition wires 411 and the size of the first wiring harness 410, further facilitating the assembly of the busbar assembly with the cylindrical power battery module to form a battery pack with high energy density.

In this embodiment, the output bar 320 and input bar 310 are both made of copper, while the current conduction bars 330 are made of aluminum. The aluminum bars are nickel-plated and soldered to the corresponding battery cells 100. A first acquisition wire 411 is soldered to the input bar 310, output bar 320, and current conduction bars 330.

In this embodiment, as shown in FIGS. 1 and 2, the wiring harness member 400 further includes at least one second acquisition wire 421 extending in the first direction for temperature signal monitoring. The at least one second acquisition wire 421 is connected in a one-to-one correspondence with at least one of the input bar 310, the output bar 320, the multiple current conduction bars 330, and the multiple battery cells 100. The input bar 310, output bar 320, and current conduction bars 330 are made of copper and aluminum, offering excellent thermal conductivity. Therefore, a second acquisition wire 421 can be selectively connected to the output bar 320, input bar 310, and current conduction bars 330, and battery cells 100 to measure stable signals from the cylindrical power battery module, thereby monitoring the charge and discharge status and whether thermal runaway is occurring, of the battery cells 100, that is, of the cylindrical power battery module. Furthermore, two second acquisition wires 421 are provided: one of the two second acquisition wires 421 is connected to the battery cells 100 closest to the input bar 310, and the other one of the two second acquisition wires 421 is connected to the battery cell 100 closest to the output bar 320. Since the primary heat source of the cylindrical power battery module during operation is the battery cells 100, in this embodiment, the second acquisition wires 421 are soldered to the battery cells 100 to more accurately monitor the temperature within the cylindrical power battery module. By acquiring temperature signals at both ends in the first direction, better thermal management simulation data can be obtained.

Like the first data acquisition wires 411, the second data acquisition wires 421 are centrally located above the current conduction bar 330, forming a second wiring harness 420. The first wiring harness 410 and the second wiring harness 420 here constitute a wiring harness member 400. Specifically, as shown in FIGS. 1 and 5, the first wiring harness 410 and the second wiring harness 420 are brought together at the side close to the input bar 310 to form the wiring harness member 400. The first wiring harness 410 and the second wiring harness 420 here may be tied together using cable ties, and may also be bonded with adhesive, or be bound by a rubber tubing to form a single strand, thereby improving the neatness of the wiring harness member 400.

In this embodiment, the second data acquisition wire 421 is connected to the battery cells 100 via a temperature monitoring element 422. The temperature monitoring element 422 here is an NTC. In other embodiments, the temperature monitoring element 422 may be other temperature monitoring devices, such as a temperature sensor, capable of monitoring the temperature signal of the battery cells 100 and transmitting this temperature signal to the BMS assembly 500 via the second data acquisition wire 421.

In this embodiment, a connector 700 is arranged at the output end of the wiring harness member 400, and the connector 700 is used for connecting, by plugging, the wiring harness member 400 to the BMS assembly 500. Directly connecting the connector 700 to the wiring harness member 400 and transferring the wiring harness member 400 to the BMS here improves the reliability of the voltage and temperature acquisition signals from the wiring harness member 400, simplifies the process, and is economical.

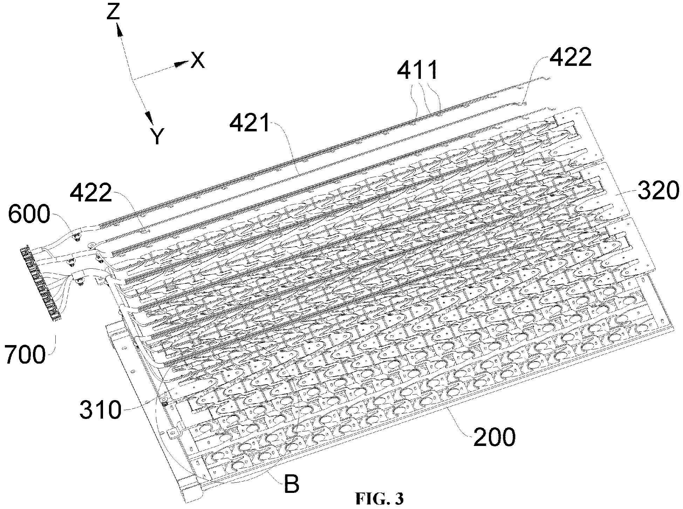

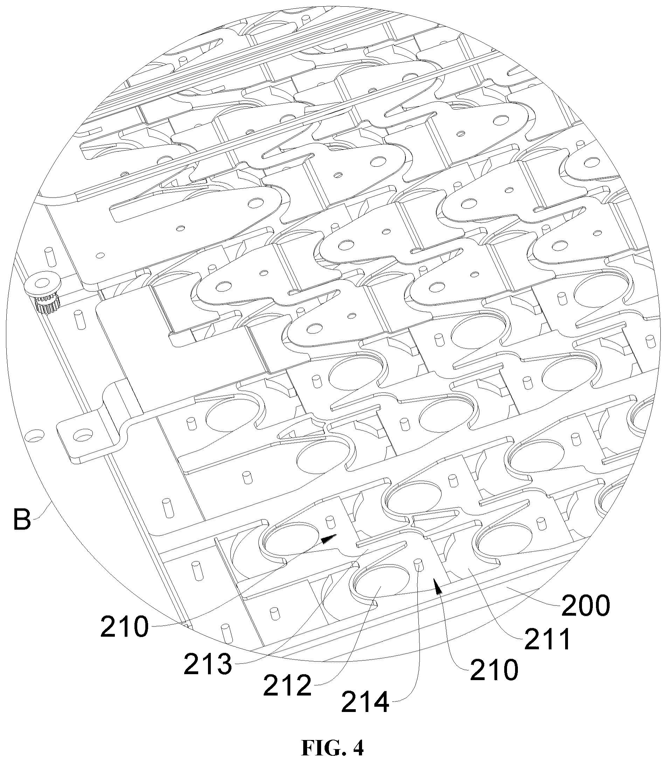

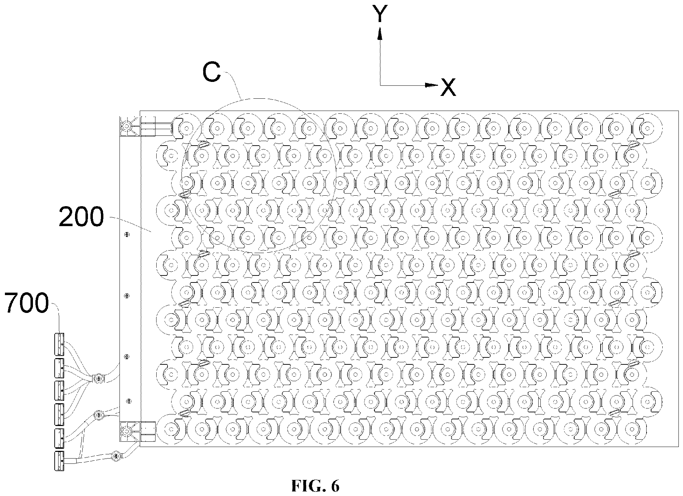

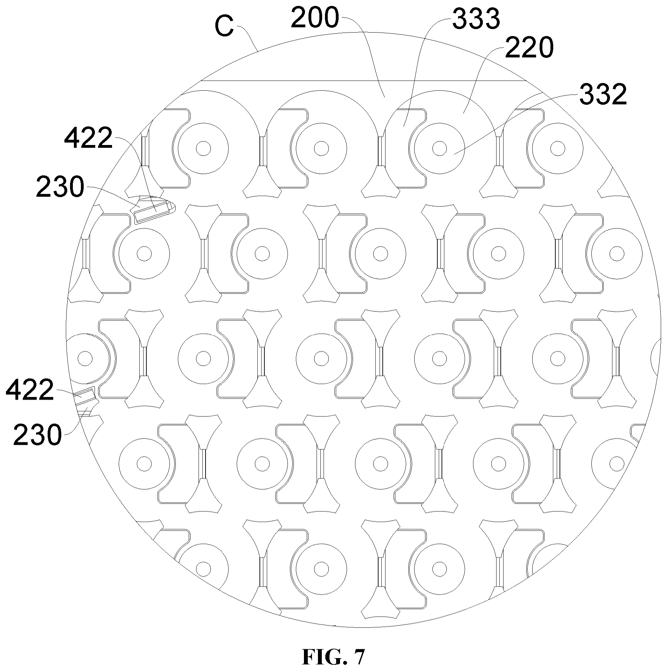

A cylindrical power battery module is further provided in this embodiment, which includes the busbar assembly described above. This facilitates monitoring temperature and voltage signals within the battery module and is cost-effective. Specifically, in this embodiment, the cylindrical power battery module includes two battery units. Furthermore, the busbar assembly further includes a plastic bracket 200, the details of which are as shown in FIGS. 3 and 4. An upper surface of the plastic bracket 200 is provided with first recesses 210, as shown in FIGS. 6 and 7, and a lower surface of the plastic bracket 200 is provided with second recesses 220 in a one-to-one correspondence with the first recesses 210. The bottom of each first recess 210 is provided with a positive electrode hole 212 and a negative electrode hole 211, which extend through the bottom of the first recess 210. During use, the battery cell 100 is inserted into the second recess 220 from bottom to top in the Z direction, the positive terminal 101 of the battery cell 100 is exposed through the positive electrode hole 212 into the first recess 210, and the negative terminal 102 of the battery cell 100 is exposed through the negative electrode hole 211 into the first recess 210. In this embodiment, the input bar 310, output bar 320, and current conduction bar 330 are all correspondingly disposed within the first recesses 210 and correspondingly connected to the positive terminals 101 and negative terminals 102 of the battery cells 100.

It is to be noted that the first recess 210 has at least three external shapes: a first recess 210 that conforms to the shape of the input bar 310, a first recess 210 that conforms to the shape of the output bar 320, and a first recess 210 that conforms to the shape of the current conduction bar 330.

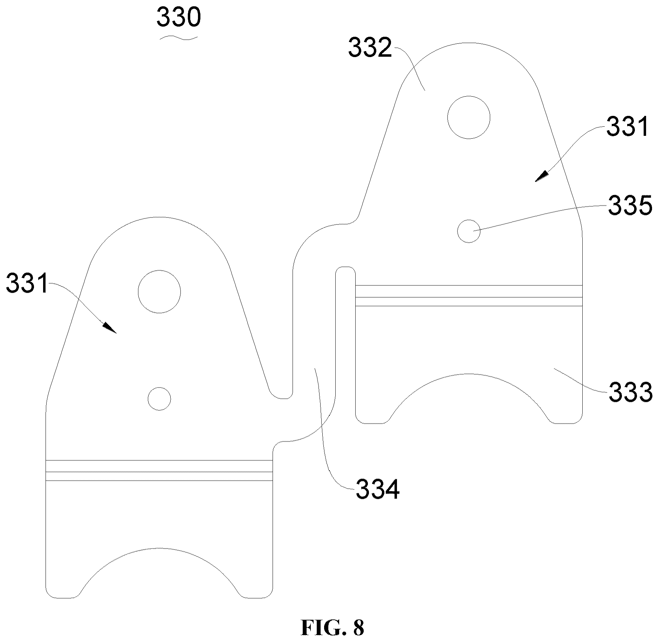

As shown in FIG. 8, in this embodiment, the current conduction bar 330 includes two conductive elements 331, which are connected by a connecting portion 334. The two conductive elements 331 correspond to two battery units. Furthermore, each of the conductive elements 331 includes a positive electrode region 332 and a negative electrode region 333. The positive electrode region 332 is designed to abut the positive terminal 101 of a battery cell 100, while the negative electrode region 333 is designed to abut the negative terminal 102 of the battery cell 100. In this embodiment, a positioning post 214 is provided at the bottom of the first recess 210, and each of the conductive elements 331 is provided with a positioning hole 335 to mate with the positioning post 214. After the current conduction bar 330 is assembled into the first recess 210, the positioning post 214 is inserted into the positioning hole 335. The positioning post 214 mating with the positioning hole 335 here facilitates quick and precise assembly of the current conduction bar 330 to the plastic bracket 200.

Accordingly, to facilitate assembly of the input bar 310 and the output bar 320, the input bar 310 and the output bar 320 may also be optionally provided with positioning holes 335 that mate with the positioning posts 214. Of course, in a case where the positioning posts 214 are provided in the first recesses 210 for assembling the input bar 310 and the output bar 320, the input bar 310 and the output bar 320 must be provided with the positioning holes 335. This facilitates positioning and assembly and prevents interference with the positioning posts 214.

In other embodiments, the positioning holes 335 may also be positioning grooves that mate with the positioning posts 214.

As shown in FIG. 4, in this embodiment, two adjacent first recesses 210 in the second direction are connected by a connecting groove 213, to fit the current conduction bar 330 formed by the two conductive elements 331 as shown in FIG. 8. The connecting groove 213 here accommodates the connecting portion 334.

In this embodiment, the plastic bracket 200 is provided with a temperature measuring hole 230 passing through the plastic bracket 200, and the temperature measuring hole 230 exposes the negative terminal 102 of the battery cell 100. The temperature monitoring element 422 is embedded in the temperature measuring hole 230 and connected to the negative terminal 102 of the battery cell 100.

A battery pack is further provided according to this embodiment, which includes at least one of the battery modules described above. Specifically, as shown in FIG. 1, the battery pack includes six battery modules, i.e., twelve battery units stacked in the second direction. Accordingly, the six wiring harness members 400 corresponding to the six battery modules are connected to a single BMS assembly 500 via respective connectors 700. It is to be noted that, to enhance integration, the six plastic brackets 200 corresponding to the six battery modules are integrally formed.

The battery pack further includes a housing (not shown), an adhesive coating layer (not shown), and a liquid cooling plate (not shown). Specifically, the six battery modules are assembled into the housing, with the coating applied to the upper surface of the busbar assembly. The liquid cooling plate is located on the upper surface of the adhesive coating layer, i.e., the liquid cooling plate is bonded to the busbar assembly by the adhesive coating layer. The adhesive coating layer here sufficiently secures the wiring harness member 400, as well as the input bar 310, output bar 320, and current conduction bar 330, to the plastic bracket 200, enhancing the structural stability of the busbar assembly, and thereby improving the safety and operational stability of the battery pack.

In this embodiment, the adhesive coating layer is a thermally conductive gel, which achieves adhesive fixation and facilitates rapid transfer of heat from the cylindrical power battery module to the liquid cooling plate, thereby facilitating rapid cooling of the cylindrical power battery module. The liquid cooling plate layout here avoids the serpentine liquid cooling plate structure of conventional cylindrical power batteries, making the battery pack more compact and improving the energy density of the battery pack.

In this embodiment, as shown in FIG. 1, a first fixing member 600 is provided on the wiring harness member 400, and a second fixing member is provided on an inner wall of the housing to mate with the first fixing member 600. The first fixing member 600 and the second fixing member are detachably connected. The first fixing member 600 mating with the second fixing member further secures the wiring harness member 400, preventing the wiring harness member 400 from shaking or pulling during use, which may disrupt the connection between the connector 700 and the BMS assembly 500. The first fixing member 600 here is a Hellermann clamp, and the second fixing member is a structure that mates with the Hellermann clamp.

In other embodiments, the first fixing member 600 and the second fixing member can also be cable ties. For example, the first fixing member 600 may be a cable tie, and the second fixing member may be a lug, buckle, or other attachment for securing the cable tie.

In some embodiments, the wiring harness members 400 for different cylindrical power battery modules within a battery pack can be bundled together to facilitate cable routing.

In this embodiment, in at least one battery module, the plastic brackets 200 of two adjacent battery modules are integrally molded to form an integrated mounting frame. The input bars 310, output bars 320, current conduction bars 330, and wiring harness members 400 corresponding to the battery modules are assembled on the integrated mounting frame. With the structural design in which the plastic brackets 200 are integrated into the integrated mounting frame and the input bars 310, output bars 320, current conduction bars 330, and wiring harness members 400 are collectively packaged on the integrated mounting frame, integrated incoming material for battery pack assembly is achieved. Specifically, after the battery cells 100 of the battery modules are arranged and laid out, the integrated mounting frame integrating the input bars 310, output bars 320, current conduction bars 330 and wiring harness members 400 can be directly mounted on the battery cells 100, which can effectively improve the assembly efficiency of the battery pack and reduce procedures of the PACK production process.

## Claims

1. A busbar assembly, applied to a cylindrical power battery module, wherein the cylindrical power battery module comprises a plurality of battery cells (100), and the busbar assembly comprises:
an input bar (310), wherein the input bar (310) is connected to the battery cell (100) at an input end of the cylindrical power battery module;
an output bar (320), wherein the output bar (320) is connected to the battery cell (100) at an output end of the cylindrical power battery module;
a current conduction bar (330) disposed between the input bar (310) and the output bar (320), wherein the current conduction bar (330) is configured to work in conjunction with the input bar (310) and the output bar (320) to connect in series in a first direction two adjacent battery cells (100) arranged in the first direction, and connect in parallel in a second direction two adjacent battery cells (100) arranged in the second direction; and
a wiring harness member (400), wherein an input end of the wiring harness member (400) is connected to at least one of the input bar (310), the output bar (320), the current conduction bar (330), and the plurality of battery cells (100), and the wiring harness member (400) is configured to monitor a voltage signal and a temperature signal of the battery cell (100) corresponding to the wiring harness member (400).

2. The busbar assembly according to claim 1, wherein the wiring harness member (400) comprises at least one first acquisition wire (411) arranged to extend in the first direction and configured to monitor a voltage signal; and
the at least one first acquisition wire (411) is connected in a one-to-one correspondence with at least one of the input bar (310), the output bar (320), a plurality of current conduction bars (330), and a plurality of battery cells (100).

3. The busbar assembly according to claim 1, wherein the wiring harness member (400) comprises a plurality of first acquisition wires (411) arranged to extend in the first direction and configured to monitor voltage signals; and
the plurality of first acquisition wires (411) are connected in a one-to-one correspondence with the input bar (310), the output bar (320), a plurality of current conduction bars (330), and a plurality of battery cells (100).

4. The busbar assembly according to claim 2 or 3, wherein the wiring harness member (400) further comprises at least one second acquisition wire (421) arranged to extend in the first direction and configured to monitor a temperature signal; and
the at least one second acquisition wire (421) is connected in a one-to-one correspondence with at least one of the input bar (310), the output bar (320), a plurality of current conduction bars (330), and a plurality of battery cells (100).

5. The busbar assembly according to claim 4, wherein at least one first acquisition wire (411) is arranged on a same side of the current conduction bar (330) in the second direction.

6. The busbar assembly according to claim 4, wherein the second acquisition wire (421) is connected to the battery cell (100) through a temperature monitoring element (422).

7. The busbar assembly according to claim 4, wherein two second acquisition wires (421) are provided, one of the two second acquisition wires (421) is connected to the battery cell (100) closest to the input bar (310), and the other of the two second acquisition wires (421) is connected to the battery cell (100) closest to the output bar (320).

8. The busbar assembly according to claim 1, wherein a connector (700) is arranged at an output end of the wiring harness member (400), and the connector (700) is configured to connect, by plugging, the wiring harness member (400) to a BMS assembly (500).

9. A cylindrical power battery module, comprising the busbar assembly according to any one of claims 1 to 8, wherein
the busbar assembly further comprises a plastic bracket (200), the input bar (310), the output bar (320), and the current conduction bar (330) are all disposed on the plastic bracket (200); and
the plastic bracket (200) is provided with a temperature measuring hole (230) passing through the plastic bracket (200), and enables the wiring harness member (400) to extend through the temperature measuring hole (230) to the battery cell (100).

10. A battery pack, comprising a housing, an adhesive coating layer, a liquid cooling plate, and at least one cylindrical power battery module according to claim 9, wherein
the battery module is disposed within the housing;
the adhesive coating layer is formed on an upper surface of the busbar assembly; and
the liquid cooling plate is located on an upper surface of the adhesive coating layer.

11. The battery pack according to claim 10, wherein a first fixing member (600) is provided on the wiring harness member (400), and a second fixing member is provided on an inner wall of the housing; and the first fixing member (600) is detachably connected to the second fixing member.

12. The battery pack according to claim 10 or 11, wherein, in the at least one battery module, the plastic brackets (200) of two adjacent battery modules are integrally molded to form an integrated mounting frame; and
the input bars (310), the output bars (320), the current conduction bars (330), and the wiring harness members (400) corresponding to the battery modules are all assembled on the integrated mounting frame.
